# FASCICULE DE BREVET EUROPEEN

(11) **EP 3 508 926 B1**
(45) Date de publication et mention de la délivrance du brevet: **06.10.2021**
(21) Numéro de dépôt: 18206333.9
(22) Date de dépôt: 14.11.2018
(51) Int. Cl.: H02J 7/00, H02J 7/34, H01L 35/32, H02J 7/02, G04C 10/02

(54) **DISPOSITIF DE RECHARGE D'UNE MONTRE ÉLECTRONIQUE OU ÉLECTROMÉCANIQUE ET ENSEMBLE LE COMPRENANT**
AUFLADEVORRICHTUNG EINER ELEKTRONISCHEN ODER ELEKTROMECHANISCHEN ARMBANDUHR, UND DIESE UMFASSENDE EINHEIT
DEVICE FOR RECHARGING AN ELECTROMECHANICAL OR ELECTRONIC WATCH AND ASSEMBLY COMPRISING SAME

(30) Priorité: 22.12.2017 EP 17210025
(43) Date de publication de la demande: 10.07.2019
(73) Titulaire: The Swatch Group Research and Development Ltd, 2074 Marin (CH)
(72) Inventeur: Haemmerli, Alexandre, 2000 Neuchâtel (CH); Tombez, Lionel, 2022 Bevaix (CH)
(74) Mandataire: ICB SA

(56) Documents cités:
- EP-A1- 1 303 022
- EP-A1- 2 384 621
- WO-A1-2015/195559
- FR-A3- 2 955 457

## Description

### DOMAINE TECHNIQUE DE L'INVENTION

L'invention concerne un ensemble comprenant un dispositif de recharge d'une montre électronique ou électromécanique, notamment un écrin de montre électronique ou électromécanique apte à recharger une telle montre, et une montre électronique ou électromécanique, équipée d'une part d'un moyen de stockage d'énergie électrique pour l'alimentation des composants électroniques de la montre, et d'autre part d'une source d'énergie électrique d'appoint apte à alimenter le moyen de stockage d'énergie électrique pour sa recharge.

### ETAT DE LA TECHNIQUE

Une montre mécanique peut être soit à remontage manuel, soit à remontage automatique. L'avantage d'un remontage automatique pour une montre mécanique est que la montre se remonte automatiquement via une masse oscillante, lorsqu'elle est portée au poignet d'une personne. Ainsi la montre ne s'arrête jamais, si elle est portée régulièrement. Tant que la montre est portée, elle ne s'arrête pas du fait des mouvements quotidiens de la personne. Dans ce domaine des montres mécaniques, on connaît des dispositifs, appelés remontoirs, qui permettent de garder une montre mécanique à remontage automatique en mouvement, même lorsqu'elle n'est pas portée. De tels remontoirs, qui se présentent par exemple sous la forme d'écrins, comprennent typiquement des moyens vibrants reliés à un moteur pour imprimer une lente rotation à la montre, et ainsi recharger le ressort du barillet de la montre via la masse oscillante. De tels remontoirs évitent ainsi l'arrêt de la montre, et permettent à cette dernière de conserver une amplitude de marche constante et donc de rester à l'heure. La demande de brevet WO 2012/126978 A1 décrit par exemple un tel remontoir pour montre mécanique. Toutefois, un inconvénient de tels remontoirs pour montres mécaniques est qu'ils ne permettent pas de recharger une montre électronique ou électromécanique équipée d'un moyen de stockage d'énergie électrique rechargeable de manière autonome. Une telle montre électronique ou électromécanique est typiquement une montre solaire ou encore une montre thermique ou thermoélectrique. Il existe encore des dispositifs de recharge pour montre électronique ou électromécanique tels que divulgués dans le document EP1303022A1.

Dans le cas d'une montre solaire, l'énergie solaire est typiquement transformée en énergie électrique au moyen d'une cellule photovoltaïque jouant le rôle de source d'énergie électrique d'appoint pour la montre. La cellule photovoltaïque est reliée à une batterie de stockage de l'énergie électrique, cette dernière faisant fonctionner le mouvement de la montre. Lorsque la montre est rangée dans un endroit sans lumière, tel qu'un tiroir ou un coffre par exemple, la batterie ne peut plus se charger et la montre s'arrête une fois la batterie vidée. Afin d'éviter une décharge complète de la montre, une solution connue consiste à ranger la montre dans un endroit éclairé lorsqu'elle n'est pas portée. Toutefois, une telle solution est peu fiable et relativement contraignante, car de tels endroits éclairés ne sont pas toujours disponibles.

Dans le cas d'une montre thermique ou thermoélectrique munie par exemple d'un générateur thermoélectrique, la montre fonctionne grâce aux pertes thermiques corporelles de la personne portant la montre. Le générateur thermoélectrique, jouant le rôle de source d'énergie électrique d'appoint, convertit ces pertes thermiques en énergie électrique pour alimenter la batterie. L'énergie stockée dans la batterie permet de faire fonctionner la montre pendant un certain temps. Toutefois, lorsque la montre n'est pas portée, la batterie se décharge, pouvant entraîner au bout d'un certain temps une décharge complète de la batterie et donc un arrêt du mouvement de la montre.

### RÉSUMÉ DE L'INVENTION

L'invention a donc pour but de fournir un dispositif de recharge d'une montre électronique ou électromécanique équipée d'un moyen de stockage d'énergie électrique rechargeable, permettant de recharger automatiquement le moyen de stockage d'énergie électrique de la montre, de manière aisée et non contraignante, et palliant les inconvénients susmentionnés de l'état de la technique.

A cet effet, l'invention concerne un ensemble comprenant un dispositif de recharge d'une montre électronique ou électromécanique et une montre électronique ou électromécanique qui comprend les caractéristiques mentionnées dans la revendication indépendante 1 et la revendication indépendante 3.

Des formes particulières de l'ensemble sont définies dans les revendications dépendantes 2 et 4 à 10.

Un avantage de l'ensemble selon l'invention réside dans le fait que le dispositif comprend au moins une source d'énergie configurée pour fournir de l'énergie à la source d'énergie électrique d'appoint, lorsque la montre est placée sur le support de réception. La source d'énergie électrique d'appoint convertit ainsi l'énergie reçue directement en énergie électrique sans passage par une conversion mécanique intermédiaire, et délivre au moyen de stockage d'énergie électrique une charge de maintien d'un niveau prédéterminé de tension d'alimentation. Ceci permet de recharger automatiquement le moyen de stockage d'énergie électrique de la montre, lorsque celle-ci n'est pas portée, et ce de manière aisée et non contraignante. L'ensemble selon l'invention permet avantageusement d'éviter une décharge complète de la montre, et donc une perte d'heure et/ou de date en résultant.

Un autre avantage de l'ensemble selon l'invention est qu'il ne requiert aucun contact galvanique entre la montre et le dispositif pour effectuer la recharge de la montre. La recharge électrique de la montre est alors effectuée de manière particulièrement aisée.

Selon un premier mode de réalisation de l'invention, ladite au moins une source d'énergie est une source de lumière, le dispositif étant un dispositif de recharge d'une montre solaire, la source d'énergie électrique d'appoint de la montre étant apte à convertir de l'énergie lumineuse en énergie électrique.

Avantageusement, le dispositif de recharge comprend des moyens d'optimisation du spectre lumineux de la source de lumière, en fonction d'au moins une caractéristique prédéterminée de la source d'énergie électrique d'appoint de la montre. Ceci permet d'adapter le spectre lumineux de la source de lumière à la performance de la source d'énergie électrique d'appoint de la montre, permettant une recharge optimale de la montre avec une consommation minimale du dispositif de recharge. De plus, le spectre lumineux peut omettre la partie infrarouge qui peut chauffer la montre, et sur la durée, la dégrader, ainsi que le dispositif de recharge.

Selon un deuxième mode de réalisation de l'invention, ladite au moins une source d'énergie est une source thermique configurée pour appliquer un gradient de température à l'intérieur du dispositif, le dispositif étant un dispositif de recharge d'une montre thermique ou thermoélectrique, la source d'énergie électrique d'appoint de la montre étant apte à convertir de l'énergie thermique en énergie électrique.

Avantageusement, le dispositif de recharge comprend des moyens d'optimisation du gradient thermique à l'intérieur du dispositif, en fonction d'au moins une caractéristique prédéterminée de la montre et/ou de la source d'énergie électrique d'appoint de la montre. Ceci permet d'adapter le gradient thermique appliqué à l'intérieur du dispositif à la construction de la montre et/ou à la performance de la source d'énergie électrique d'appoint de la montre, permettant une recharge optimale de la montre avec une consommation minimale du dispositif de recharge.

Selon l'invention, le dispositif de recharge comprend une pièce de rabat montée sur le coffret, et un capteur de présence de la montre et/ou de fermeture de la pièce de rabat; ledit capteur étant relié à la source d'énergie, la source d'énergie étant configurée pour déclencher une émission d'énergie à destination de la source d'énergie électrique d'appoint de la montre sur la base d'un signal de détection reçu du capteur. Ceci permet d'automatiser complètement le processus de recharge de la montre, à partir du moment où la montre est placée sur le support de réception et/ou la pièce de rabat est refermée.

Avantageusement, la montre électronique ou électromécanique comprend en outre un extracteur d'énergie reliant la source d'énergie électrique d'appoint au moyen de stockage d'énergie électrique, la source d'énergie étant configurée pour fournir de l'énergie à la source d'énergie électrique d'appoint, lorsque la montre est placée sur le support de réception, afin que ladite source d'énergie électrique d'appoint convertisse l'énergie reçue en énergie électrique par l'intermédiaire de l'extracteur d'énergie. Ceci permet de faciliter l'extraction d'énergie depuis la source d'énergie et sa conversion en charges électriques afin d'accumuler ces charges sur le moyen de stockage d'énergie électrique de la montre.

Des formes particulières de l'ensemble sont définies dans les revendications dépendantes 2 et 4 à 10.

### BRÈVE DESCRIPTION DES FIGURES

Les buts, avantages et caractéristiques du dispositif de recharge d'une montre électronique ou électromécanique, ainsi que de l'ensemble le comprenant, apparaîtront mieux dans la description suivante sur la base d'au moins une forme d'exécution non limitative illustrée par les dessins sur lesquels :
- la figure 1 est une vue en perspective d'un ensemble selon l'invention, comprenant une montre électronique ou électromécanique et un dispositif de recharge, le dispositif de recharge se présentant sous la forme d'un écrin,
- la figure 2 représente un schéma bloc simplifié des composants électroniques de la montre et du dispositif de recharge de la figure 1 selon un exemple de réalisation,
- la figure 3 est une vue en perspective d'un ensemble comprenant un dispositif de recharge d'une montre solaire, selon un premier mode de réalisation de l'invention, et
- la figure 4 est une vue en coupe verticale d'une partie d'un ensemble comportant un dispositif de recharge d'une montre thermique ou thermoélectrique, selon un deuxième mode de réalisation de l'invention.

### DESCRIPTION DETAILLEE DE L'INVENTION

Dans la description suivante, il est fait référence à un dispositif de recharge d'une montre électronique ou électromécanique, notamment un écrin pour montre électronique ou électromécanique. Tous les composants électroniques du dispositif de recharge, qui sont bien connus d'un homme du métier dans ce domaine technique, ne sont décrits que de manière simplifiée. En particulier, l'homme du métier saura adapter ces différents composants électroniques et les faire coopérer pour le fonctionnement du dispositif.

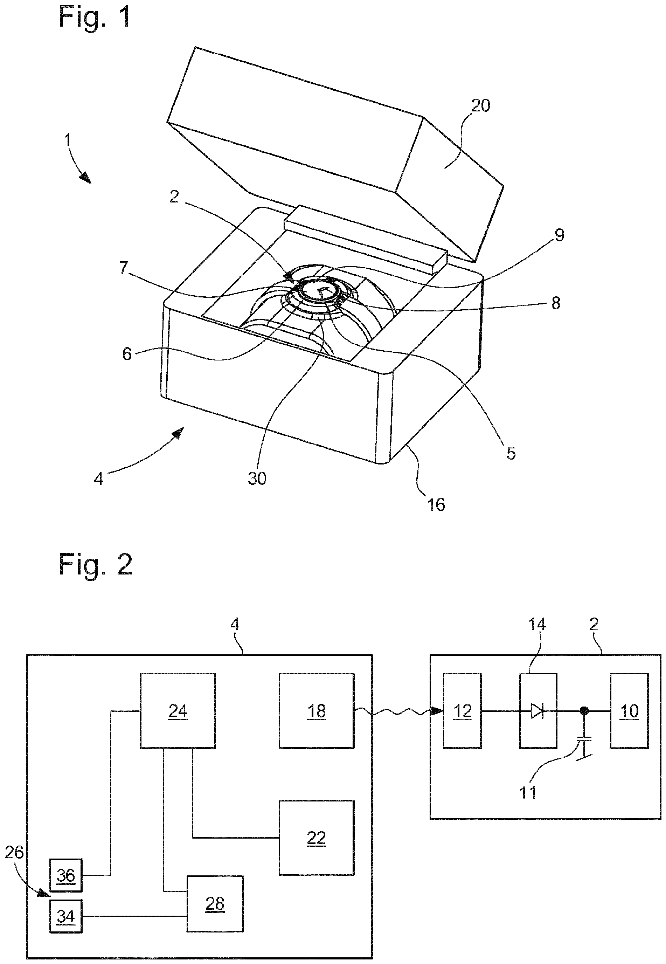

Les figures 1 et 2 représentent un ensemble 1, qui comprend une montre électronique ou électromécanique 2 et un dispositif 4 de recharge de la montre 2. La montre électronique ou électromécanique 2 est munie d'une boîte de montre 5. La boîte de montre 5 comprend une carrure 6. La boîte de montre 5 renferme un mouvement d'horlogerie (non représenté) de construction usuelle, ainsi qu'un cadran 7 au-dessus duquel se déplacent des moyens d'affichage par exemple formés d'aiguilles 8. Le cadran 7 est protégé par une glace 9, qui vient refermer la boîte de montre 5. De manière classique, la boîte de montre 5 renferme également des composants électroniques 10 nécessitant une alimentation électrique, ainsi qu'un moyen de stockage d'énergie électrique 11 pour l'alimentation des composants électroniques 10 de la montre 2. La montre 2 comprend en outre une source d'énergie électrique d'appoint 12 apte à alimenter le moyen de stockage d'énergie électrique 11 pour sa recharge. La source d'énergie électrique d'appoint 12 peut être agencée à l'intérieur de la boîte de montre 5 ou, en variante, être disposée à l'extérieur de celle-ci, par exemple sur la glace 9 ou la carrure 6 ou le bracelet de la montre. De préférence, comme illustré sur la figure 2, la montre 2 comprend également un extracteur d'énergie 14 reliant la source d'énergie électrique d'appoint 12 au moyen de stockage d'énergie électrique 11. La montre 2 est par exemple une montre à quartz ou une montre mécanique hybride, sans que cela ne soit limitatif dans le cadre de la présente invention.

Le dispositif de recharge 4 comprend un coffret 16. Dans l'exemple illustratif de la figure 1, le dispositif de recharge 4 est un écrin de réception de la montre 2. Cela n'est toutefois nullement limitatif dans le cadre de la présente invention, et le dispositif de recharge 4 peut en variante adopter toute autre forme disposant d'un coffret, différente d'un écrin.

Comme illustré sur la figure 2, le dispositif de recharge 4 comprend en outre au moins une source d'énergie 18. Dans l'exemple de réalisation illustré sur la figure 1, le dispositif de recharge 4 comprend en outre une pièce de rabat 20, montée sur le coffret 16. Dans le cas où le dispositif de recharge 4 est un écrin de réception de la montre 2, la pièce de rabat 20 est typiquement un couvercle de fermeture de l'écrin. Selon un exemple de réalisation préférentiel illustré sur la figure 2, le dispositif de recharge 4 comprend également un capteur 22 de présence de la montre 2 et/ou de fermeture de la pièce de rabat 20. De préférence, le dispositif de recharge 4 peut comporter en outre des moyens 24 d'analyse de données, des moyens de communication 26, et des moyens d'alimentation électrique 28.

De préférence, le dispositif de recharge 4 est configuré pour contenir un type et/ou une forme de montre électronique ou électromécanique 2 prédéfini(es). Pour ce faire, le coffret 16 comprend un support 30 de réception de la montre 2, adapté au type et/ou à la forme de la montre 2.

Comme cela sera détaillé par la suite, la source d'énergie 18 est configurée pour fournir de l'énergie à la source d'énergie électrique d'appoint 12 lorsque la montre 2 est placée sur le support de réception 30, afin que la source d'énergie électrique d'appoint 12 convertisse l'énergie reçue en énergie électrique et délivre au moyen de stockage d'énergie électrique 11 une charge de maintien d'un niveau prédéterminé de tension d'alimentation. Cette conversion d'énergie électrique peut par exemple être facilitée par l'extracteur d'énergie 14. L'extracteur d'énergie 14, qui comprend par exemple un circuit oscillateur de type LC, un générateur de signal d'horloge tel qu'un oscillateur à quartz, et un ou plusieurs interrupteurs associés à un circuit de commande commun, facilite ainsi l'extraction de charges électriques depuis la source d'énergie électrique d'appoint 12, et permet l'accumulation de ces charges sur le moyen de stockage d'énergie électrique 11 de la montre 2. Comme représenté sur la figure 2, le moyen de stockage d'énergie électrique 11 est par exemple un condensateur électrique. En variante, le moyen de stockage d'énergie électrique 11 est une batterie.

Le capteur 22 de présence de la montre 2 et/ou de fermeture de la pièce de rabat 20 est relié aux moyens 24 d'analyse de données, euxmêmes reliés à la source d'énergie 18. Le capteur 22 de présence de la montre 2 et/ou de fermeture de la pièce de rabat 20 est par exemple fixé dans le dispositif de recharge 4, à l'intérieur ou à l'extérieur du support de réception 30. Le capteur 22 de présence de la montre est par exemple un palpeur agencé dans le dispositif de recharge 4 de sorte à être en regard du côté du fond 32 de la boîte de montre 5, lorsque la montre 2 est placée sur le support de réception 30, en regard de ce fond 32. En variante non représentée, le capteur de présence de la montre 2 et/ou de fermeture de la pièce de rabat 20 est constitué d'un système optique de détection de position des aiguilles 8 de la montre 2, tel qu'un capteur optique ou une caméra par exemple. Les moyens 24 d'analyse de données sont par exemple configurés pour déclencher un processus d'émission d'énergie à destination de la source d'énergie électrique d'appoint 12 de la montre 2 sur la base d'un signal de détection reçu du capteur 22, comme cela sera détaillé par la suite.

Comme représenté sur la figure 2, les moyens 24 d'analyse de données sont reliés en outre aux moyens de communication 26 et aux moyens d'alimentation électrique 28. Les moyens 24 d'analyse de données sont par exemple constitués d'un microprocesseur. Le microprocesseur stocke notamment une référence de temps.

Comme illustré sur la figure 2, les moyens de communication 26 comprennent par exemple une prise micro-USB (de l'anglais Universal Serial Bus) 34 et une interface de communication 36. La prise micro-USB 34 est reliée aux moyens d'alimentation électrique 28 et est destinée à permettre une recharge électrique de ces derniers, via une source d'alimentation électrique extérieure compatible avec le format USB. L'interface de communication 36 est par exemple un écran tactile, permettant à un utilisateur d'entrer des informations utiles, notamment des informations relatives au type ou au modèle de la montre 2. De telles informations, une fois communiquées aux moyens 24 d'analyse de données, permettent alors d'accéder à des caractéristiques prédéterminées de la source d'énergie électrique d'appoint 12 de la montre 2, notamment des caractéristiques de puissance thermique ou lumineuse, ou de spectre lumineux. Ceci est par exemple rendu possible via une table de correspondance stockée dans les moyens d'analyse 24.

Les moyens d'alimentation électrique 28 comprennent par exemple un ensemble chargeur / accumulateur, notamment dans le cas où les moyens de communication 26 comprennent une prise micro-USB 34. En variante, les moyens d'alimentation électrique 28 comprennent une batterie, rechargeable ou non. En variante encore, l'alimentation électrique du dispositif de recharge 4 est fournie via un raccordement du dispositif 4 au réseau électrique domestique, les moyens d'alimentation électrique 28 comprenant par exemple dans ce cas un ensemble chargeur / accumulateur. Selon ces deux dernières variantes, les moyens de communication 26 ne comprennent pas de prise micro-USB 34.

Les moyens 24 d'analyse de données, les moyens de communication 26, et les moyens d'alimentation électrique 28 sont par exemple tous connectés sur un circuit imprimé commun, un tel circuit imprimé n'étant pas représenté sur les figures pour des raisons de clarté.

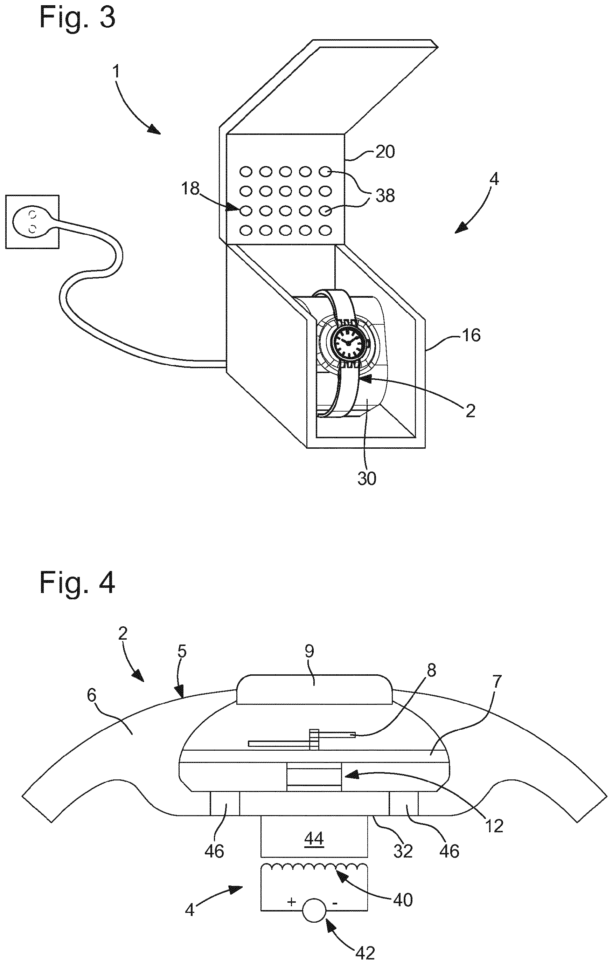

Un premier mode de réalisation de l'invention va maintenant être décrit en référence à la figure 3. Selon ce premier mode de réalisation, la source d'énergie 18 est une source de lumière et le dispositif 4 est un dispositif de recharge d'une montre solaire 2. Dans une telle montre solaire 2, la source d'énergie électrique d'appoint 12 est apte à convertir de l'énergie lumineuse en énergie électrique. La source d'énergie électrique d'appoint 12 est par exemple une cellule photovoltaïque, par exemple disposée sur le cadran 7 de la montre 2.

La source de lumière 18 comprend par exemple au moins une diode électroluminescente 38. Dans l'exemple de réalisation illustré sur la figure 3, la source de lumière 18 comprend plusieurs diodes électroluminescentes 38 disposées en rangées à l'intérieur de la pièce de rabat 20. Plus précisément, les diodes électroluminescentes 38 sont fixées à l'intérieur de la pièce de rabat 20 de sorte à être en regard de la source d'énergie électrique d'appoint 12 de la montre 2 lorsque la pièce de rabat 20 est refermée sur le coffret 16 et que la montre 2 est placée sur le support de réception 30. La source de lumière 18 est par exemple activable par les moyens 24 d'analyse de données, et est configurée pour pouvoir être activée en permanence ou, en variante, à intervalles réguliers programmables.

De préférence, selon ce premier mode de réalisation de l'invention, le dispositif de recharge 4 comprend en outre des moyens d'optimisation du spectre lumineux de la source de lumière 18, en fonction d'au moins une caractéristique prédéterminée de la source d'énergie électrique d'appoint 12 de la montre 2. Les moyens d'optimisation du spectre lumineux sont par exemple constitués des moyens 24 d'analyse de données, qui peuvent stocker une table de correspondance entre des informations de types ou de modèles de montres et des caractéristiques lumineuses prédéterminées de sources d'énergie électrique d'appoint 12. En fonction du type et/ou du modèle de la montre 2 placée sur le support de réception 30, les moyens 24 d'analyse de données sont alors configurés pour commander et ajuster le spectre lumineux de la source de lumière 18, en vue d'optimiser ce spectre lumineux et de l'adapter aux caractéristiques lumineuses de la source d'énergie électrique d'appoint 12 de la montre 2. Ceci permet d'optimiser et d'ajuster précisément la quantité d'énergie fournie par le dispositif 4, afin de prolonger la durée de vie du moyen de stockage d'énergie électrique 11 de la montre 22, ainsi que celle consommée par le dispositif de recharge.

Un deuxième mode de réalisation de l'invention va maintenant être décrit en référence à la figure 4. Selon ce deuxième mode de réalisation, la source d'énergie 18 est une source thermique et le dispositif 4 est un dispositif de recharge d'une montre thermique ou thermoélectrique 2. Dans une telle montre thermique ou thermoélectrique 2, la source d'énergie électrique d'appoint 12 est apte à convertir de l'énergie thermique en énergie électrique. La source d'énergie électrique d'appoint 12 est par exemple un générateur thermoélectrique. Un tel générateur thermoélectrique est un dispositif à semi-conducteur, par exemple un dispositif à semi-conducteur mettant en œuvre une jonction P-N. Une telle jonction P-N est par exemple constituée d'éléments en tellure de bismuth (Bi₂Te₃). Les générateurs thermoélectriques à semi-conducteur sont configurés pour convertir un flux thermique (sous forme de différentiel de températures) directement en énergie électrique via un phénomène appelé l'effet Seebeck (une forme d'effet thermoélectrique). De tels générateurs thermoélectriques fonctionnent comme des moteurs thermiques, mais sont moins encombrants et n'ont pas de parties mobiles. Dans l'exemple illustratif de la figure 4, le générateur thermoélectrique 12 est agencé à l'intérieur de la boîte de montre 5, entre le cadran 7 et le fond 32 de la boîte de montre 5.

La source thermique 18 est configurée pour appliquer un gradient de température à l'intérieur du dispositif de recharge 4.

Selon une première variante du deuxième mode de réalisation, illustrée sur la figure 4, la source thermique 18 est une source thermique activable par les moyens 24 d'analyse de données. La source thermique 18 est configurée pour appliquer, lorsqu'activée, des cycles de température, et donc des gradients thermiques, à l'intérieur du dispositif 4. De préférence, la source thermique 18 est apte à être activée à intervalles réguliers programmables. Dans cette première variante de réalisation illustrée sur la figure 4, la source thermique 18 comprend par exemple un élément chauffant 40, une source électrique 42 connectée en série de l'élément chauffant 40, et un posage 44 en contact avec le fond 32 de la boîte de montre 5. L'élément chauffant 40 est par exemple constitué d'un corps de chauffe résistif ou encore d'une résistance en serpentin. L'élément chauffant 40 peut être remplacé par un élément réfrigérant sans modifier le fonctionnement de cette variante de réalisation. La source électrique 42 est par exemple une source de tension électrique. Le posage 44, qui appartient au support de réception 30, est agencé en regard de l'élément chauffant 40 et est constitué d'un matériau métallique. Le matériau métallique est par exemple de l'aluminium. Dans cette variante de réalisation illustrée sur la figure 4, le fond 32 de la boîte de montre 5 est réalisé dans un matériau conducteur de chaleur, de préférence un matériau métallique. Le fond 32 est séparé du reste de la boîte de montre 5 par une zone annulaire 46 réalisée dans un matériau isolant thermique.

Selon une deuxième variante du deuxième mode de réalisation, non représentée sur les figures, le dispositif de recharge 4 comprend deux sources d'énergie thermique 18. Une première source thermique 18 comprend un élément chauffant agencé dans le coffret 16 de sorte à être en contact avec le fond 32 de la boîte de montre 5 lorsque la montre 2 est placée sur le support de réception 30. Une deuxième source d'énergie 18 comprend un élément refroidissant agencé dans le dispositif 4 de sorte à être en contact avec la carrure 6 de la montre 2 lorsque la montre 2 est placée sur le support de réception 30. De cette manière, les deux sources thermiques 18 appliquent un gradient thermique constant à l'intérieur du dispositif 4. L'élément chauffant est par exemple constitué d'un corps de chauffe résistif ou encore d'une résistance en serpentin. L'élément refroidissant est par exemple un élément de refroidissement actif, tel qu'un élément Peltier ou encore un ventilateur. En variante, l'élément refroidissant est un élément de refroidissement passif tel que par exemple un radiateur en aluminium en contact avec la carrure 6 de la montre 2.

Selon le type et/ou le modèle de la montre 2 ainsi que le type de générateur thermoélectrique 12 utilisé, le gradient thermique entre la carrure 6 de la montre 2 et le fond 32 de la boîte de montre 5 se situe préférentiellement dans une plage comprise entre 0,1°C et 10°C. La mesure de température est par exemple effectuée au moyen de deux thermomètres, un premier thermomètre étant en contact avec la partie chaude, c'est-à-dire le fond 32 de la montre 2; un deuxième thermomètre étant en contact avec la partie froide, c'est-à-dire la carrure 6 de la montre 2. Les deux thermomètres sont par exemple des thermocouples. Un système de boucle fermé simple de type PID (Proportionnel Intégral Dérivé) est alors utilisé pour réguler le gradient thermique à l'intérieur du dispositif 4.

De préférence, selon ce deuxième mode de réalisation de l'invention, le dispositif de recharge 4 comprend en outre des moyens d'optimisation du gradient thermique à l'intérieur du dispositif 4, en fonction d'au moins une caractéristique prédéterminée de la montre 2 et/ou de la source d'énergie électrique d'appoint 12 de la montre 2. Les moyens d'optimisation du gradient thermique sont par exemple constitués des moyens 24 d'analyse de données, qui peuvent stocker une table de correspondance entre des informations de types ou de modèles de montres et des caractéristiques thermiques prédéterminées de sources d'énergie électrique d'appoint 12. En fonction du type et/ou du modèle de la montre 2 placée sur le support de réception 30, les moyens 24 d'analyse de données sont alors configurés pour commander et ajuster le gradient thermique émis par la source thermique 18, en vue d'optimiser ce gradient thermique et de l'adapter aux caractéristiques thermiques de la source d'énergie électrique d'appoint 12 de la montre 2. Ceci permet d'optimiser et d'ajuster précisément la quantité d'énergie fournie par le dispositif 4, afin de prolonger la durée de vie du moyen de stockage d'énergie électrique 11 de la montre 22 avec une consommation minimale du dispositif de recharge.

Le fonctionnement de l'ensemble selon l'invention, comportant un dispositif de recharge 4 va maintenant être décrit. La montre 2 est initialement placée dans le coffret 16 du dispositif de recharge 4, sur le support de réception 30.

Le procédé de recharge de la montre 2, mis en œuvre par le dispositif 4, peut être déclenché soit manuellement par un utilisateur, soit automatiquement.

Le procédé peut comprendre une étape initiale au cours de laquelle un utilisateur du dispositif 4 entre, via l'interface de communication 36, des informations relatives au type ou au modèle de la montre 2. En variante, la montre 2 est équipée d'une puce, par exemple une puce de type NFC (de l'anglais Near Field Communication), stockant des informations relatives à la source d'énergie électrique d'appoint 12 de la montre 2, notamment des caractéristiques lumineuses ou thermiques. Le dispositif 4 est alors configuré pour lire de telles informations au sein de la puce, lorsque la montre 2 est placée sur le support de réception 30.

Dans le cas d'un déclenchement manuel du procédé par un utilisateur, ce dernier, après avoir refermé la pièce de rabat 20, appuie par exemple sur un bouton de déclenchement du procédé.

Dans le cas où le dispositif de recharge 4 comprend un capteur 22 de présence de la montre 2 et/ou de fermeture de la pièce de rabat 20, le déclenchement du procédé de recharge est effectué automatiquement, suite à une détection du capteur 22. Le capteur 22 transmet alors un signal de détection aux moyens d'analyse 24, ce qui déclenche le procédé de recharge de la montre 2.

Dans les deux cas, la ou les source(s) d'énergie 18, commandée(s) par les moyens d'analyse 24, déclenche(nt) une émission d'énergie à destination de la source d'énergie électrique d'appoint 12 de la montre 2. De préférence, les moyens d'analyse 24 accèdent, par exemple via une table de correspondance, à des caractéristiques prédéterminées de la source d'énergie électrique d'appoint 12 de la montre 2, notamment des caractéristiques de puissance thermique ou lumineuse, ou de spectre lumineux. Les moyens d'analyse 24 peuvent alors optimiser et ajuster précisément la quantité d'énergie fournie par la ou les source(s) d'énergie 18 en fonction du type de source d'énergie électrique d'appoint 12 utilisée. La source d'énergie électrique d'appoint 12 convertit ensuite l'énergie reçue en énergie électrique et délivre au moyen de stockage d'énergie électrique 11 une charge de maintien d'un niveau prédéterminé de tension d'alimentation, permettant la recharge de la montre 22 avec une consommation minimale du dispositif de recharge.

## Revendications

1. Ensemble (1) comprenant un dispositif (4) de recharge d'une montre électronique ou électromécanique (2), et une montre électronique ou électromécanique (2) équipée d'une part d'un moyen de stockage d'énergie électrique (11) pour l'alimentation des composants électroniques (10) de la montre (2), et d'autre part d'une source d'énergie électrique d'appoint (12) apte à alimenter directement et électriquement sans conversion mécanique intermédiaire le moyen de stockage d'énergie électrique (11) pour sa recharge, le dispositif (4) comprenant un coffret (16) muni d'un support (30) de réception de la montre (2), le dispositif (4) comprenant en outre au moins une source d'énergie (18) configurée pour fournir de l'énergie à la source d'énergie électrique d'appoint (12) de la montre, lorsque la montre (2) est placée sur le support de réception (30), ladite au moins une source d'énergie (18) étant une source de lumière, le dispositif (4) étant un dispositif de recharge d'une montre solaire, la source d'énergie électrique d'appoint (12) de la montre (2) étant apte à convertir de l'énergie lumineuse en énergie électrique, **caractérisé en ce que** le dispositif comprend une pièce de rabat (20) montée sur le coffret (16), et **en ce que** la source de lumière (18) comprend au moins une diode électroluminescente (38), la diode électroluminescente (38) étant fixée à l'intérieur de la pièce de rabat (20) de sorte à être en regard de la source d'énergie électrique d'appoint (12) de la montre (2), lorsque la pièce de rabat (20) est refermée sur le coffret (16) et que la montre (2) est placée sur le support de réception (30).

2. Ensemble (1) selon la revendication 1 **caractérisé en ce qu'**il comprend des moyens (24) d'optimisation du spectre lumineux de la source de lumière (18), en fonction d'au moins une caractéristique prédéterminée de la source d'énergie électrique d'appoint (12) de la montre (2).

3. Ensemble (1) comprenant un dispositif (4) de recharge d'une montre électronique ou électromécanique (2), et une montre électronique ou électromécanique (2) équipée d'une part d'un moyen de stockage d'énergie électrique (11) pour l'alimentation des composants électroniques (10) de la montre (2), et d'autre part d'une source d'énergie électrique d'appoint (12) apte à alimenter directement et électriquement sans conversion mécanique intermédiaire le moyen de stockage d'énergie électrique (11) pour sa recharge, le dispositif (4) comprenant un coffret (16) muni d'un support (30) de réception de la montre, le dispositif comprenant en outre une source d'énergie (18) configurée pour fournir de l'énergie à la source d'énergie électrique d'appoint (12) de la montre, lorsque la montre (2) est placée sur son support de réception (30), **caractérisé en ce que** ladite au moins une source d'énergie (18) est une source thermique configurée pour appliquer un gradient de température entre deux parties définies de la montre à l'intérieur du dispositif (4), le dispositif (4) étant un dispositif de recharge d'une montre thermique ou thermoélectrique, la source d'énergie électrique d'appoint (12) de la montre (2) étant apte à convertir de l'énergie thermique en énergie électrique.

4. Ensemble (1) selon la revendication 3, **caractérisé en ce que** la source thermique (18) est une source thermique activable, configurée pour appliquer, lorsqu'activée, des cycles de température à la montre à l'intérieur du dispositif (4).

5. Ensemble (1) selon la revendication 4, **caractérisé en ce que** la source thermique (18) est apte à être activée à intervalles réguliers programmables.

6. Ensemble (1) selon la revendication 3, **caractérisé en ce qu'**il comprend deux sources d'énergie thermique (18), une première source thermique (18) comprenant un élément chauffant agencé dans le coffret de sorte à être en contact avec un fond (32) de la boîte (5) de la montre (2), lorsque la montre (2) est placée sur le support de réception (30); une deuxième source d'énergie (18) comprenant un élément refroidissant agencé dans le dispositif (4) de sorte à être en contact avec une carrure (6) de la montre (2), lorsque la montre (2) est placée sur le support de réception (30).

7. Ensemble (1) selon l'une des revendications 3 à 6, **caractérisé en ce qu'**il comprend des moyens (24) d'optimisation du gradient thermique à l'intérieur du dispositif (4), en fonction d'au moins une caractéristique prédéterminée de la montre (2) et/ou de la source d'énergie électrique d'appoint (12) de la montre (2).

8. Ensemble (1) selon l'une quelconque des revendications précédentes, **caractérisé en ce qu'**il comprend une pièce de rabat (20) montée sur le coffret (16), et un capteur (22) de présence de la montre (2) et/ou de fermeture de la pièce de rabat (20); ledit capteur (22) étant relié à la source d'énergie (18), la source d'énergie (18) étant configurée pour déclencher une émission d'énergie à destination de la source d'énergie électrique d'appoint (12) de la montre (2) sur la base d'un signal de détection reçu du capteur (22).

9. Ensemble (1) selon l'une quelconque des revendications précédentes, **caractérisé en ce que** le dispositif (4) est un écrin de réception de la montre (2).

10. Ensemble (1) selon la revendication 1, **caractérisé en ce que** la montre électronique ou électromécanique (2) comprend en outre un extracteur d'énergie (14) reliant la source d'énergie électrique d'appoint (12) au moyen de stockage d'énergie électrique (11), la source d'énergie (18) étant configurée pour fournir de l'énergie à la source d'énergie électrique d'appoint (12), lorsque la montre (2) est placée sur le support de réception (30), afin que ladite source d'énergie électrique d'appoint (12) convertisse l'énergie reçue en énergie électrique par l'intermédiaire de l'extracteur d'énergie (14).

## Patentansprüche

1. Einheit (1), die eine Aufladevorrichtung (4) einer elektronischen oder elektromechanischen Uhr (2) und eine elektronische oder elektromechanische Uhr (2) umfasst, die einerseits mit einem Mittel zum Speichern elektrischer Energie (11) zur Versorgung der elektronischen Komponenten (10) der Uhr (2), und andererseits mit einer elektrischen Hilfsenergiequelle (12) ausgerüstet ist, die imstande ist, das Mittel zum Speichern elektrischer Energie (11) zu dessen Aufladung, direkt und elektrisch ohne mechanische Zwischenkonvertierung zu versorgen, wobei die Vorrichtung (4) ein Gehäuse (16) umfasst, das mit einer Stütze (30) zur Aufnahme der Uhr (2) versehen ist,
wobei die Vorrichtung (4) weiter mindestens eine Energiequelle (18) umfasst, die konfiguriert ist, um der elektrischen Hilfsenergiequelle (12) der Uhr Energie bereitzustellen, wenn die Uhr (2) auf der Stütze (30) zur Aufnahme platziert ist, wobei die mindestens eine Energiequelle (18) eine Lichtquelle ist, wobei die Vorrichtung (4) eine Aufladevorrichtung einer Sonnenuhr ist, wobei die elektrische Hilfsenergiequelle (12) der Uhr (2) imstande ist, Lichtenergie in elektrische Energie zu konvertieren, **dadurch gekennzeichnet, dass** die Vorrichtung ein Klappenstück (20) umfasst, das an dem Gehäuse (16) montiert ist, und dadurch, dass die Lichtquelle (18) mindestens eine Elektrolumineszenzdiode (38) umfasst, wobei die Elektrolumineszenzdiode (38) derart im Inneren des Klappenstücks (20) fixiert ist, um gegenüber der elektrischen Hilfsenergiequelle (12) der Uhr (2) zu liegen, wenn das Klappenstück (20) auf dem Gehäuse (16) verschlossen ist, und die Uhr (2) auf der Stütze (30) zur Aufnahme platziert ist.

2. Einheit (1) nach Anspruch 1, **dadurch gekennzeichnet, dass** sie Mittel (24) zur Optimierung des Lichtspektrums der Lichtquelle (18) in Abhängigkeit von mindestens einem vorbestimmten Merkmal der elektrischen Hilfsenergiequelle (12) der Uhr (2) umfasst.

3. Einheit (1), die eine Aufladevorrichtung (4) einer elektronischen oder elektromechanischen Uhr (2) und eine elektronische oder elektromechanische Uhr (2) umfasst, die einerseits mit einem Mittel zum Speichern elektrischer Energie (11) zur Versorgung der elektronischen Komponenten (10) der Uhr (2), und andererseits mit einer elektrischen Hilfsenergiequelle (12) ausgerüstet ist, die imstande ist, das Mittel zum Speichern elektrischer Energie (11) zu dessen Aufladung, direkt und elektrisch ohne mechanische Zwischenkonvertierung zu versorgen, wobei die Vorrichtung (4) ein Gehäuse (16) umfasst, das mit einer Stütze (30) zur Aufnahme der Uhr versehen ist, wobei die Vorrichtung weiter mindestens eine Energiequelle (18) umfasst, die konfiguriert ist, um der elektrischen Hilfsenergiequelle (12) der Uhr Energie bereitzustellen, wenn die Uhr (2) auf der Stütze (30) zur Aufnahme platziert ist, **dadurch gekennzeichnet, dass** die mindestens eine Lichtquelle (18) eine Wärmequelle ist, die konfiguriert ist, um einen Temperaturgradienten zwischen zwei definierten Teilen der Uhr im Inneren der Vorrichtung (4) anzuwenden, wobei die Vorrichtung (4) eine Aufladevorrichtung einer thermischen oder thermoelektrischen Uhr ist, wobei die elektrische Hilfsenergiequelle (12) der Uhr (2) imstande ist, Wärmeenergie in elektrische Energie zu konvertieren.

4. Einheit (1) nach Anspruch 3, **dadurch gekennzeichnet, dass** die Wärmequelle (18) eine aktivierbare Wärmequelle ist, die konfiguriert ist, um, wenn aktiviert, Temperaturzyklen auf die Uhr im Inneren der Vorrichtung (4) anzuwenden.

5. Einheit (1) nach Anspruch 4, **dadurch gekennzeichnet, dass** die Wärmequelle (18) imstande ist, in regelmäßigen programmierbaren Intervallen aktiviert zu werden.

6. Einheit (1) nach Anspruch 3, **dadurch gekennzeichnet, dass** sie zwei Wärmequellen (18) umfasst, wobei eine erste Wärmequelle (18) ein Heizelement umfasst, das derart in dem Gehäuse angeordnet ist, um in Kontakt mit einem Boden (32) des Gehäuses (5) der Uhr (2) zu sein, wenn die Uhr (2) auf der Stütze (30) zur Aufnahme platziert ist; wobei eine zweite Energiequelle (18) ein Element zum Abkühlen umfasst, das derart in der Vorrichtung (4) angeordnet ist, um in Kontakt mit einem Mittelteil (6) der Uhr (2) zu sein, wenn die Uhr (2) auf der Stütze (30) zur Aufnahme platziert ist.

7. Einheit (1) nach einem der Ansprüche 3 bis 6, **dadurch gekennzeichnet, dass** sie Mittel (24) zum Optimieren des Wärmegradienten im Inneren der Vorrichtung (4) in Abhängigkeit von mindestens einem vorbestimmten Merkmal der Uhr (2) und/oder der elektrischen Hilfsenergiequelle (12) der Uhr (2) umfasst.

8. Einheit (1) nach einem der vorstehenden Ansprüche, **dadurch gekennzeichnet, dass** sie ein Klappenstück (20) umfasst, das an dem Gehäuse (16) montiert ist, und einen Präsenzmelder (22) der Uhr (2) und/oder eines Verschlusses des Klappenstücks (20); wobei der Melder (22) mit der Energiequelle (18) verbunden ist, wobei die Energiequelle (18) konfiguriert ist, um eine Energiesendung an die elektrische Hilfsenergiequelle (12) der Uhr (2) auf der Basis eines von dem Melder (22) empfangenen Erkennungssignals auszulösen.

9. Einheit (1) nach einem der vorstehenden Ansprüche, **dadurch gekennzeichnet, dass** die Vorrichtung (4) ein Ecrin zur Aufnahme der Uhr (2) ist.

10. Einheit (1) nach Anspruch 1, **dadurch gekennzeichnet, dass** die elektronische oder elektromechanische Uhr (2) weiter einen Energieextraktor (14) umfasst, der die elektrische Hilfsenergiequelle (12) mit dem Mittel zum Speichern elektrischer Energie (11) verbindet, wobei die Energiequelle (18) konfiguriert ist, um der elektrischen Hilfsenergiequelle (12) Energie bereitzustellen, wenn die Uhr (2) auf der Stütze (30) zur Aufnahme platziert ist, damit die elektrische Hilfsenergiequelle (12) die empfangene Energie anhand des Energieextraktors (14) in elektrische Energie konvertiert.

## Claims

1. Assembly (1) comprising a recharging device (4) for an electronic or electromechanical watch (2), and an electronic or electromechanical watch equipped, on the one hand, with a means for the storage of electrical energy (11) for powering electronic components (10) of the watch (2) and, on the other hand, with an auxiliary source of electrical energy (12) adapted to power the means for the storage of electrical energy (11) directly and electrically without intermediate mechanical conversion for recharging thereof, the device (4) comprising a casket (16) provided with a support (30) for receiving the watch (2),
the device (4) further comprising at least one source of energy (18) configured to supply energy to the auxiliary source of electrical energy (12) for the watch, when the watch (2) is placed on the receiving support (30), said at least one source of energy (18) being a source of light, the device (4) being a recharging device for a solar-powered watch, the auxiliary source of electrical energy (12) for the watch (2) being adapted to convert luminous energy into electrical energy, **characterised in that** the device comprises a folding piece (20) mounted on the casket (16), and **in that** the source of light (18) comprises at least one light-emitting diode (38), the light-emitting diode (38) being fixed to the interior of the folding piece (20) so as to be facing towards the auxiliary source of electrical energy (12) for the watch (2), when the folding piece (20) is closed onto the casket (16) and when the watch (2) is placed on the receiving support (30).

2. Assembly (1) according to claim 1, **characterised in that** it comprises means (24) for optimising the light spectrum of the source of light (18), depending on at least one predetermined characterising feature of the auxiliary source of electrical energy (12) for the watch (2).

3. Assembly (1) comprising a recharging device (4) for an electronic or electromechanical watch (2), and an electronic or electromechanical watch (2) equipped, on the one hand, with a means for the storage of electrical energy (11) for powering electronic components (10) of the watch (2) and, on the other hand, with an auxiliary source of electrical energy (12) adapted to power the means for the storage of electrical energy (11) directly and electrically without intermediate mechanical conversion for recharging thereof, the device (4) comprising a casket (16) provided with a support (30) for receiving the watch, the device further comprising a source of energy (18) configured to supply energy to the auxiliary source of electrical energy (12) for the watch, when the watch (2) is placed on the receiving support (30), **characterised in that** said at least one source of energy (18) is a thermal source configured to apply a temperature gradient between two defined parts of the watch in the interior of the device (4), the device (4) being a recharging device for a thermic or thermoelectric watch, the auxiliary source of electrical energy (12) for the watch (2) being adapted to convert the thermal energy into electrical energy.

4. Assembly (1) according to claim 3, **characterised in that** the thermal source (18) is an activatable thermal source configured, when activated, to apply temperature cycles to the watch in the interior of the device (4).

5. Assembly (1) according to claim 4, **characterised in that** the thermal source (18) is adapted to be activated at regular programmable intervals.

6. Assembly (1) according to claim 3, **characterised in that** it comprises two sources of thermal energy (18), a first thermal source (18) comprising a heating element arranged in the casket so that it is in contact with a back (32) of the case (5) of the watch (2), when the watch (2) is placed on the receiving support (30), a second source of energy (18) comprising a cooling element arranged in the device (4) so that it is in contact with a case middle (6) of the watch (2), when the watch (2) is placed on the receiving support (30).

7. Assembly (1) according to one of claims 3 to 6, **characterised in that** it comprises means (24) for optimising the thermal gradient in the interior of the device (4), depending on at least one predetermined characterising feature of the watch (2) and/or of the auxiliary source of electrical energy (12) for the watch (2).

8. Assembly (1) according to any one of the preceding claims, **characterised in that** it comprises a folding piece (20) mounted on the casket (16), and a sensor (22) for the presence of the watch (2) and/or the closing of the folding piece (20), said sensor (22) being connected to the source of energy (18), the source of energy (18) being configured to trigger the release of energy intended for the auxiliary source of electrical energy (12) for the watch (2) on the basis of a detection signal received from the sensor (22).

9. Assembly (1) according to any one of the preceding claims, **characterised in that** the device (4) is a box for receiving the watch (2).

10. Assembly (1) according to claim 1, **characterised in that** the electronic or electromechanical watch (2) further comprises an energy extractor (14) connecting the auxiliary source of electrical energy (12) to the means for the storage of electrical energy (11), the source of energy (18) being configured to supply energy to the auxiliary source of electrical energy (12), when the watch (2) is placed on the receiving support (30), in order for said auxiliary source of electrical energy (12) to convert the received energy into electrical energy by means of the energy extractor (14).
